# EUROPEAN PATENT APPLICATION

(11) **EP 4 601 008 A1**
(43) Date of publication of application: **13.08.2025**
(21) Application number: 24156454.1
(22) Date of filing: 08.02.2024
(51) Int. Cl.: H01L 27/02

(54) **PROTECTION CIRCUIT**

(71) Applicant: Infineon Technologies Dresden GmbH & Co . KG, 01099 Dresden (DE)
(72) Inventor: WEIS, Rolf, 01109 Dresden (DE); MAHMOUD, Ahmed, 85345 Freising (DE)
(74) Representative: Westphal, Mussgnug & Partner, Patentanwälte mbB

(57) **Abstract**

An electronic circuit is disclosed. The electronic circuit includes first and second circuit nodes (11, 12); a bipolar transistor (2) including an emitter region (21) connected to one of the first and second circuit nodes (11, 12), a collector region (22) connected to the other one of the first and second circuit nodes (11, 12), and a base region (23); a trigger element (3) connected between the emitter region (21) and the base region (23) of the bipolar transistor (2); and an Avalanche diode (4). The bipolar transistor (2) and the Avalanche diode (3) are integrated in a semiconductor body (100), wherein the emitter region (21) and the collector region (23) are spaced apart from each other in a lateral direction of the semiconductor body (100), and wherein the base region (23) and the collector region (22) of the bipolar transistor (2), at the same time, form the Avalanche diode (4).

## Description

This disclosure relates in general to a protection circuit, such as an electrostatic discharge (ESD) protection circuit.

Voltage or current pulses (spikes), such as voltage or current pulses caused by electrostatic discharge (ESD) events or by electrical overstress (EOS) may cause damages or reliability problems in semiconductor devices or in integrated circuits (ICs) that include several semiconductor devices. In an ESD process electric charge is transferred in short time from an object, such as a charged person, a charged electrical cable, or charged manufacturing equipment, to a circuit node connected to the semiconductor device or the IC. A voltage or current spike may damage or destroy the semiconductor device or the IC. Damages induced by voltage or current spikes are, for example: interruption of a connection line by melting the connection line; failure caused by thermal semiconductor junction burn-out; or destruction or degradation of a gate oxide of a semiconductor device such as MOSFET (Metal-Oxide Field-Effect Transistor) or an IGBT (Insulated Gate Bipolar Transistor).

Different concepts are known for protecting semiconductor devices or ICs against voltage or current spikes resulting from ESD events. According to one concept, a transistor, such as a MOSFET or an IGBT, has its load path connected in parallel to the semiconductor device or the IC to be protected. Further, a control circuit is connected in parallel to the load path of the transistor and is configured to switch on the transistor when the voltage across the load path reaches a trigger voltage. In the on-state, the transistor provides a low-ohmic current path for conducting the current occurring in connection with the ESD event.

There is a need for a protection circuit, such as an ESD protection circuit, that can be implemented in a space-saving way and in which a trigger voltage can be easily adjusted by design.

One example relates to an electronic circuit. The electronic circuit includes first and second circuit nodes; a bipolar transistor with an emitter region connected to one of the first and second circuit nodes, a collector region connected to the other one of the first and second circuit nodes, and a base region; a trigger element connected between the emitter region and the base region of the bipolar transistor; and an Avalanche diode. The bipolar transistor and the Avalanche diode are integrated in a semiconductor body, wherein the emitter region and the collector region are spaced apart from each other in a lateral direction of the semiconductor body, and wherein the base region and the collector region of the bipolar transistor, at the same time, form the Avalanche diode.

Examples are explained below with reference to the drawings. The drawings serve to illustrate certain principles, so that only aspects necessary for understanding these principles are illustrated. The drawings are not to scale. In the drawings the same reference characters denote like features.
Figure 1 illustrates a circuit diagram of a protection circuit that includes a bipolar transistor, and Avalanche diode, and a trigger element;
Figure 2 schematically illustrates a vertical cross-sectional view of one section of a semiconductor body to illustrate one example for integrating the bipolar transistor and the Avalanche diode in a semiconductor body;
Figures 3 and 4 illustrate different examples of an optional carrier on top of which the bipolar transistor and the Avalanche diode are formed in the semiconductor body 100;
Figures 5A and 5B illustrate a vertical cross-sectional view (Figure 5A) and a top view (Figure 3B) of one section of a semiconductor body to illustrate another example for integrating the bipolar transistor and the Avalanche diode;
Figure 6 illustrates an example of the protection circuit in which the trigger element is implemented as a resistor;
Figure 7 illustrates an example of the protection circuit in which the trigger element is implemented as a diode arrangement;
Figure 8 illustrates one example of the protection circuit in which the trigger element is integrated in a polysilicon layer arranged above a first surface of a semiconductor body; and
Figure 9 illustrates a cross-sectional view of a polysilicon layer in which a trigger element implemented as a diode is integrated.

In the following detailed description, reference is made to the accompanying drawings. The drawings form a part of the description and for the purpose of illustration show examples of how the invention may be used and implemented. It is to be understood that the features of the various embodiments described herein may be combined with each other, unless specifically noted otherwise.

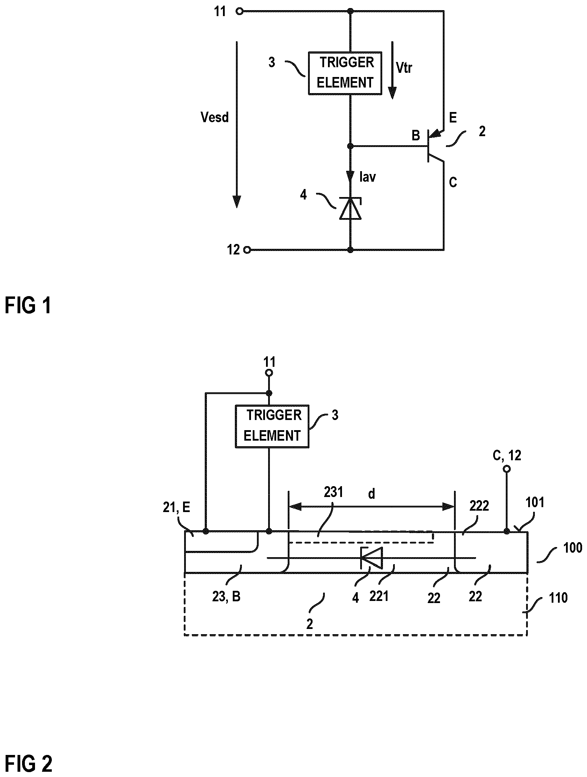

Figure 1 shows a circuit diagram of an electronic circuit according to one example. More specifically, Figure 1 shows a circuit diagram of a protection circuit that is configured to clamp (limit) a voltage Vesd applied between first and second circuit nodes 11, 12 of the protection circuit. The protection circuit according to Figure 1 may be connected to any kind of electronic device or electronic circuit (not illustrated in Figure 1) that is to be protected against high voltages, in particular high voltages resulting from an ESD event. The electronic device to be protected may be a MOSFET, for example. In this example, the protection circuit, via the first and second circuit nodes 11, 12, may be connected between a drain node and a source node of the MOSFET or between a gate node and a source node.

Referring to Figure 1, the protection circuit includes a bipolar transistor 2, a trigger element 3, and an Avalanche diode 4. The bipolar transistor 2 includes an emitter node E, a collector node C, and a base node B. A collector-emitter path of the bipolar transistor 2, which is an internal path of the bipolar transistor 2 between the emitter node E and the collector node C, is connected between the first and second circuit nodes 11, 12. For this, in the example illustrated in Figure 1, the emitter node E is connected to the first circuit node 11 and the collector node is connected to the second circuit node 12 of the protection circuit.

Referring to Figure 1, the trigger element 3 is connected between the emitter node E and the base node B of the bipolar transistor 2, and the Avalanche diode 4 is connected between the base node B and the collector node C. In this way the trigger element 3 and the Avalanche diode 4 are connected in series between the first and second circuit nodes 11, 12.

The protection circuit is configured to clamp (limit) the voltage Vesd applied between the first and second circuit nodes 11, 12 such that a voltage level of the voltage Vesd does not significantly exceed a predefined maximum voltage level. The voltage Vesd applied between the first and second circuit nodes 11, 12 may result from an ESD event, so that this voltage is also referred to as ESD voltage in the following.

The maximum voltage level to which the ESD voltage Vesd is clamped (limited) is referred to as clamping voltage in the following. The clamping voltage is mainly dependent on a breakdown voltage (Avalanche voltage) of the Avalanche diode 4. When the voltage level of The ESD voltage Vesd reaches the breakdown voltage of the Avalanche diode 4, the Avalanche diode 4 starts conducting an Avalanche current Iav. The Avalanche current Iav causes a voltage drop Vtr across the trigger element 3. This voltage Vtr is referred to as trigger voltage in the following. The bipolar transistor 2 switches on to provide a conducting current path in parallel with the series circuit including the trigger element 3 and the Avalanche diode 4 when the trigger voltage Vtr reaches a threshold voltage of the bipolar transistor 2. The "threshold voltage" of the bipolar transistor 2 is a voltage level of a voltage between the base node B and the emitter node E (base-emitter voltage) at which the bipolar transistor 2 switches on.

According to one example (as illustrated in Figure 1) the bipolar transistor is a PNP transistor. In this example, the threshold voltage is a negative voltage between the base and emitter nodes B, E. According to one example, the bipolar transistor is a silicon based bipolar transistor. In this example, the negative threshold voltage is about -0.7V, so that the bipolar transistor 2 switches on when the base-emitter voltage becomes lower than the negative threshold voltage.

Figure 2 schematically illustrates one example for integrating the bipolar transistor 2 and the Avalanche diode 4 in a semiconductor body 100. More specifically, Figure 2 schematically illustrates a vertical cross-sectional view of one section of a semiconductor body 100 in which the bipolar transistor 2 and the Avalanche diode 4 are integrated. The trigger element 3 is only schematically illustrated in Figure 2. Examples of the trigger element 3 are explained herein further below.

At least a region of the semiconductor body 100 in which the bipolar transistor 2 and the Avalanche diode 4 are integrated includes a monocrystalline semiconductor material such as, for example, silicon (Si) or silicon carbide (SiC).

Referring to Figure 2, the bipolar transistor 2 includes an emitter region 21, a collector region 22, and a base region 23. The emitter region 21 is connected the emitter node E or forms the emitter node E, the collector region 22 is connected to the collector node C or forms the collector node C, and the base region 22 is connected to the base node B or forms the base node B.

Referring to Figure 2, the emitter region 21 and the collector region 22 are spaced apart from each other in a lateral direction of the semiconductor body 100. The lateral direction is a direction that is essentially parallel to a first surface 101 of the semiconductor body. The emitter region 21 and the collector region 22 are separated from one another by the base region 23.

In the protection circuit according to Figure 2, the base region 23 and the collector region 22 of the bipolar transistor 2, at the same time, form the Avalanche diode 4. In a PNP bipolar transistor, for example, the base region 23 is an N-type region and the collector region 22 is a P-type region, so that the base region 23 forms a cathode of the Avalanche diode 4 and the collector region 22 forms an anode of the Avalanche diode 4. For the purpose of illustration, the circuit symbol of the Avalanche diode 4 formed by the base and collector regions 23, 22 of the bipolar transistor 2 is also illustrated in Figure 2.

Referring to Figure 2, the collector region 22 may include a first region 221 and a second region 222, wherein the first region 221 adjoins the base region 23 and is arranged between the base region 23 and the second region 222. The first region 221 has a lower doping concentration than the second region 222, according to one example. According to one example, the doping concentration of the second region 222 is at least 10 times, at least 100 times, or at least 1000 times the doping concentration of the first region 221.

According to one example, the doping concentration of the first region 221 is selected from between 1E14 cm⁻³ and 1E16 cm⁻³. The doping concentration of the second region 222 is selected from between 1E17 cm⁻³ and 1E19 cm⁻³, for example. Doping concentrations of the base region 23 and the emitter region 21 may be selected from the same range as the doping concentration of the second region 222 of the collector region 22. It should be noted that each of the emitter region 21, the base region 23 and the second collector region 222 may have a (top) contact region (not illustrated) in a section adjoining the first surface 101. The contact regions may have a higher doping concentration than the remainder of the respective region 21, 23, 222. These contact regions serve to provide an ohmic contact to the respective region 21, 23, 222. Doping concentrations of the contact regions are selected from a range of between 1E19 cm⁻³ and 1E21 cm⁻³

According to one example illustrated in dashed lines in Figure 2, the base region 23 includes a base region extension 231 of the first doping type that extends along portions of the first region 221 in the direction of the second region 222 and adjoins portions of the first collector region 221. The base region extension 231 may adjoin the second region 222 or may be spaced apart from the second region 222. A doping concentration of the base region extension is between 1E15 cm⁻³ and 1E18 cm⁻³, for example.

Referring to the above, the Avalanche diode 4 is formed between the base region 23 and the collector region 22. In the presence of the base region extension 231 and the first collector region 221 form a portion of the Avalanche diode 4. The base extension region 231 and the first collector region 221 form a superjunction (resurf) structure.

In the protection circuit according to Figure 2, the breakdown voltage of the Avalanche diode 4 is dependent on a dimension d of the first region 221 in the lateral direction. This dimension of the first region 221 in the lateral direction of the semiconductor body 100 equals a distance between the base region 23 and the second region 222 of the collector region 22 in the lateral direction. At a given doping concentration of the base region 23, the first region 221 and the second region 222, the larger the distance d between the base region 23 and the second region 222 the higher the breakdown voltage of the Avalanche diode 4. At a doping concentration of the first region 221 of about
2E16 cm⁻³, for example, the breakdown voltage is about 150 V when the distance d is about 10 micrometers (µm). The breakdown voltage is about 200 V, for example, when the distance d is about 15 micrometers. Thus, in the protection circuit according to Figure 2, the breakdown voltage of the Avalanche diode 4 and, therefore, the clamping voltage of the protection circuit, can easily be adjusted by suitably designing the distance between the base region 23 and the second region 222 of the collector region 22.

According to one example, the breakdown voltage of the Avalanche diode 4 is selected from between 30V and 1000 V. In this example, the distance between the base region 23 and the second region 222 of the collector region 22 is selected from between 1 micrometer and 100 micrometers.

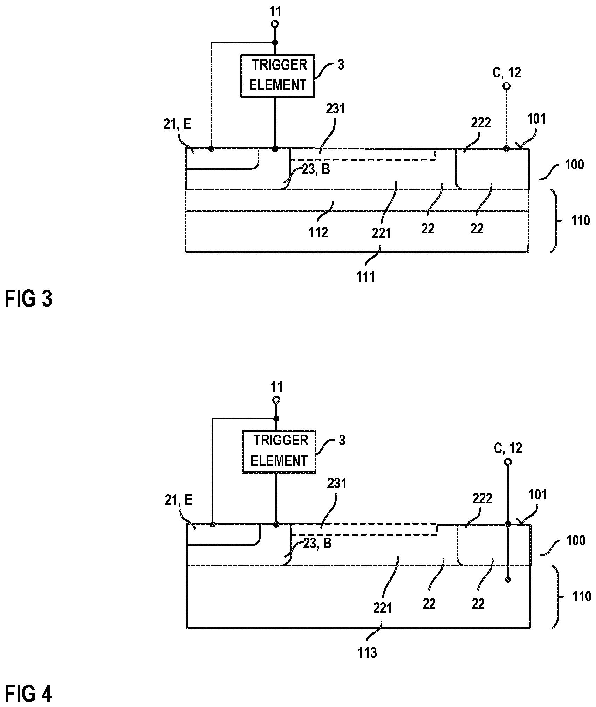

In Figure 2, only the portion of the semiconductor body 100 that includes the emitter, collector, and base regions 21, 22, 23 is illustrated. The semiconductor body 100 may include further portions such as a portion 110 that provides for mechanic stability of the semiconductor body 100. This stabilizing portion 110, which is also referred to as carrier portion in the following, is illustrated in dashed lines in Figure 2. The carrier portion 110 may be implemented in various ways. Two different examples are explained with reference to Figures 3 and 4 in the following.

Referring to Figure 3, the carrier portion 110 may include a semiconductor substrate 111 and an insulating layer 112 formed on top of the semiconductor substrate 111. The bipolar transistor 2 and the Avalanche diode 4 are integrated in a semiconductor layer formed on top of the insulating layer 112. The semiconductor substrate 111, the insulating layer 112, and the semiconductor layer including the bipolar transistor 2 and the Avalanche diode 4 may be formed by an SOI substrate.

According to another example illustrated in Figure 4, the carrier portion 110 includes a semiconductor substrate 113. The semiconductor substrate 113 may have the same doping type as the emitter and collector regions 21, 22. According to one example, the bipolar transistor 2 and the Avalanche diode 4 are formed in an epitaxial layer formed on top of the semiconductor substrate 113. According to another example, the bipolar transistor 2 and the Avalanche diode 4 are integrated in the substrate 113 and may be formed using at least one of an implantation and diffusion process.

The semiconductor substrate 113 may have the same doping concentration or a lower doping concentration than the first region 221 of the collector region 22. Examples of the doping concentration of the first collector region 221 are explained with reference to Figure 2 hereinabove. According to one example, the collector node C is ohmically connected to the substrate 113. Such connection is schematically illustrated in Figure 4.

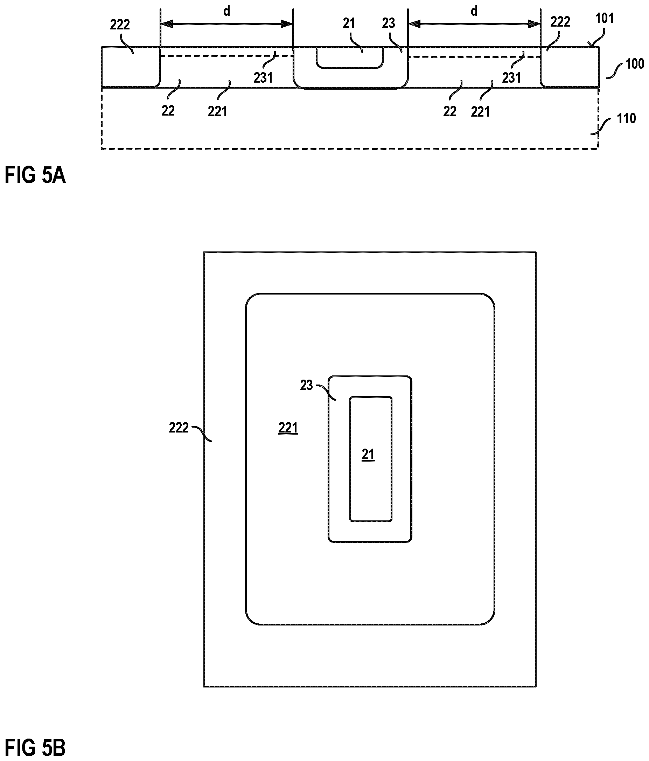

According to one example illustrated in Figures 5A and 5B, the collector region 22 with the first region 221 and second regions 222, in a horizontal plane of the semiconductor body 100, surrounds the emitter and base regions 21, 23 in a ring-shaped fashion. Figure 5A shows a vertical cross sectional view of the semiconductor body 100 and Figure 5B shows a top view of the first surface 101 of the semiconductor body 100. In each lateral direction, the shortest distance between the base region 23 and the second region 222 of the collector region 22 is given by the distance d that defines the breakdown voltage of the Avalanche diode.

Referring to the above, the trigger element 3 conducts the Avalanche current Iav and generates the trigger voltage Vtr between the base and emitter nodes B, E of the bipolar transistor 2 in order to switch on the bipolar transistor. The trigger element 3 may be implemented in various ways.

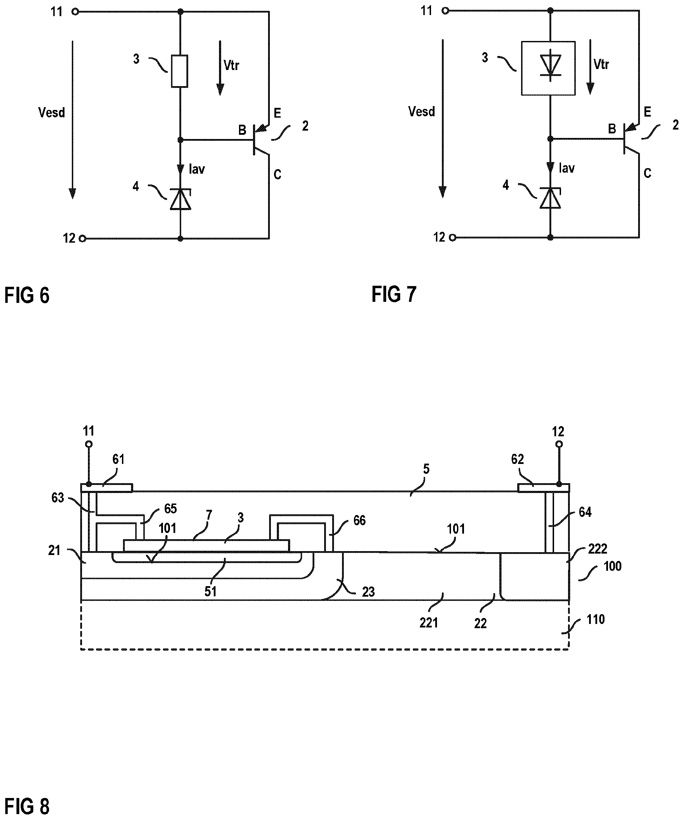

According to one example illustrated in Figure 6, the trigger element is a resistor 3 connected between the first circuit node 11 and the base node B of the bipolar transistor 2. A resistance of the resistor 3 is selected such that the Avalanche current Iav through the Avalanche diode 4 generates the trigger voltage Vtr such that the trigger voltage switches on the bipolar transistor 2.

According to another example illustrated in Figure 7, the trigger element 3 is a diode arrangement connected between the first circuit node 11 and the base node B of the bipolar transistor 2. The diode arrangement includes at least one diode and may include several diodes connected in series. In the example illustrated in Figure 7, in which the bipolar transistor 2 is a PNP transistor, an anode node of the at least one diode is connected to the first circuit node 11 and a cathode node of the at least one diode is connected to the base node B of the bipolar transistor 2. The diode arrangement forming the trigger element 3 and the bipolar transistor 2 are adapted to one another such that a forward voltage of the diode is high enough to switch on the bipolar transistor 2. The "forward voltage" is the voltage between the anode node and the cathode node of the diode when the diode is forward biased by the Avalanche current Iav.

According to one example illustrated in Figure 8, the trigger element 3 is formed in a polysilicon layer 7 formed above the first surface 101 of the semiconductor body 100. As illustrated in Figure 8, the polysilicon layer 7 may formed above the emitter region 21 of the bipolar transistor 2. The polysilicon layer 7, in a vertical direction of the semiconductor body 100, is spaced apart from the first surface 101 of the semiconductor body 100 and is separated from the semiconductor body 100 by an insulating layer 5. The "vertical direction" of the semiconductor body 100 is a direction that is essentially perpendicular to the first surface 101.

According to one example, the polysilicon layer 7 is embedded in the insulating layer 5. The insulating layer 5 may include several insulating portions. According to one example, the insulating layer 5 includes a shallow trench isolation (STI) 51 on top of which the polysilicon layer 7 is formed. This example is illustrated in Figure 8. The STI 51 causes a dip in the first surface 101 of the semiconductor body 100, so that the first surface 101 may have surface sections on different vertical levels of the semiconductor body 100.

Forming the STI 51 may include an oxidation process in which monocrystalline portions of the semiconductor body 100 are transformed into an oxide, so that the first surface 101 of the semiconductor body 100 at a bottom of the STI is at a level that is different from the level of a remainder of the first surface 101.

Forming the polysilicon layer 7 on top of STI 51, however, is only an example. According to another example, a first portion of the insulating layer 5 is deposited on the first surface 101 of the semiconductor body, the polysilicon layer 7 is formed on top of this first portion of the insulating layer 5, and further portions of the insulating layer 5 are deposited in order to cover the polysilicon layer 7.

Referring to Figure 8, the protection circuit may further include a first electrical contact 61 and a second electrical contact 62 each formed on top of the insulating layer 5. Each of the first and second contacts 61, 62 includes an electrically conducting material such as a metal. The first contact 61 is connected to the first circuit node 11 or forms the first circuit node 11 of the protection circuit, and the second contact 62 is connected to the second circuit node 12 or forms the second circuit node 12 of the protection circuit. The first contact 61 is connected to the emitter region 21 of the bipolar transistor 2 via a first electrically conducting via 63 that extends from the emitter region 21 through the insulating layer 5 to the first contact 61. The second contact 62 is connected to the collector region 22 of the bipolar transistor via a second electrically conducting via 64 that extends from the collector region 22 through the insulating layer 5 to the second contact 62. More specifically, the second region 222 of the collector region 22 is connected to the second contact 62 via the second via 64.

As explained before, the trigger element 3 is connected between the first circuit node 11 and the base region 23 of the bipolar transistor 2. For this, in the example illustrated in Figure 8, a first portion of the polysilicon layer 7 is connected to the first circuit node 11. For connecting the first portion of the polysilicon layer 7 to the first contact 61, the first portion of the polysilicon layer 7 may be connected to the first via 63 via a first conductor 65. Furthermore, a second portion of the polysilicon layer 7 is connected to the base region 23 via a second conductor 66. Each of the first and second conductors 65, 66 includes an electrically conducting material and may be formed within the insulating layer 5 in a conventional way.

Within the polysilicon layer 7, the trigger element 3 is formed between the first portion connected to the first conductor 65 and the second portion connected to the second conductor 66. According to one example explained above, the trigger element 3 is a resistor. In this example, a resistance of the resistor is dependent on a doping concentration and a size of the polysilicon layer 7. Thus, the resistance of the resistor can be adjusted by suitably selecting the doping concentration of the polysilicon layer and suitably designing the size of the polysilicon layer 7.

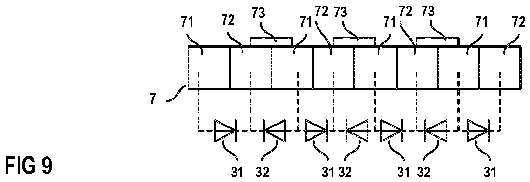

According to another example explained above, the trigger element 3 includes a diode arrangement. One example for implementing a diode arrangement as the trigger element 3 in the polysilicon layer 7 is illustrated in Figure 9.

Figure 9 schematically illustrates a vertical cross-sectional view of the polysilicon layer 7 in which a diode arrangement 3 as the trigger element is integrated. In this example, the diode arrangement 3 includes a plurality of diodes connected in series.

In the example illustrated in Figure 9, the polysilicon layer 7 includes a plurality of first regions 71 having a first doping type and second regions 72 having a second doping type complementary to the first doping type. The first and second regions 71, 72 are arranged alternatingly in the polysilicon layer. The first regions 71 are P-type regions and the second regions 72 are N-type regions, for example.

Each pair including a first region 71 and an adjoining second region 72 forms a PN junction therebetween, so that each pair including a first region 71 and an adjoining second region 72 forms a diode 31, 32 of the diode arrangement 3. The diodes 31, 32 include first diodes 31 and second diodes 32, wherein the first diodes 31 and the second diodes second 32 are connected in anti-series. Circuit symbols of the first and second diodes 31, 32 are also illustrated in Figure 9.

Referring to Figure 9, the diode arrangement 3 further includes short-circuit elements 73 formed on top of the polysilicon layer 7. Each of these short-circuit elements short-circuits the PN junction of a respective second diode 32, so that a series circuit including the first diodes 31 is electrically active in the diode arrangement. A forward voltage of the diode arrangement 3 is given by a sum of the forward voltages of the first diodes 31 in the diode arrangement.

Some of the aspects explained above are briefly summarized in the following with reference to numbered examples.

Example 1. An electronic circuit, comprising: first and second circuit nodes; a bipolar transistor comprising an emitter region connected to one of the first and second circuit nodes, a collector region connected to the other one of the first and second circuit nodes, and a base region; a trigger element connected between the emitter region and the base region of the bipolar transistor; and an Avalanche diode, wherein the bipolar transistor and the Avalanche diode are integrated in a semiconductor body, wherein the emitter region and the collector region are spaced apart from each other in a lateral direction of the semiconductor body, and wherein the base region and the collector region of the bipolar transistor, at the same time, form the Avalanche diode.

Example 2. The electronic circuit of example 1, wherein the base region of the bipolar transistor is arranged between the emitter region and the collector region, wherein the collector region includes a first region adjoining the base region and a second region separated from the base region by the first region, wherein the first region has a lower doping concentration than the second region.

Example 3. The electronic circuit of example 2, wherein a distance between the base region and the second region of the collector region is selected from between 1 micrometer and 100 micrometers.

Example 4. The electronic circuit of any one of examples 1 to 3, wherein the base region, in a lateral plane of the semiconductor body, surrounds the emitter region, and wherein the collector region, in the lateral plane of the semiconductor body surrounds the base region.

Example 5. The electronic circuit of any one of examples 1 to 4, wherein the trigger element comprises a resistor.

Example 6. The electronic circuit of any one of examples 1 to 4, wherein the trigger element comprises a diode.

Example 7. The electronic circuit of any one of examples 1 to 6, wherein the trigger element is integrated in a polysilicon layer formed above a first surface of the semiconductor body.

Example 8. The electronic circuit of any one of examples 1 to 7, wherein the bipolar transistor is a PNP bipolar transistor.

Example 9. The electronic circuit of any one of examples 1 to 8, wherein a breakdown voltage of the Avalanche diode is between 30 V and 1000 V.

## Claims

1. An electronic circuit, comprising:
first and second circuit nodes (11, 12);
a bipolar transistor (2) comprising an emitter region (21) connected to one of the first and second circuit nodes (11, 12), a collector region (22) connected to the other one of the first and second circuit nodes (11, 12), and a base region (23);
a trigger element (3) connected between the emitter region (21) and the base region (23) of the bipolar transistor (2); and
an Avalanche diode (4),
wherein the bipolar transistor (2) and the Avalanche diode (3) are integrated in a semiconductor body (100),
wherein the emitter region (21) and the collector region (23) are spaced apart from each other in a lateral direction of the semiconductor body (100), and
wherein the base region (23) and the collector region (22) of the bipolar transistor (2), at the same time, form the Avalanche diode (4).

2. The electronic circuit of claim 1,
wherein the base region (23) of the bipolar transistor (2) is arranged between the emitter region (21) and the collector region (22),
wherein the collector region (22) includes a first region (221) adjoining the base region (23) and a second region (222) separated from the base region (23) by the first region (221),
wherein the first region (221) has a lower doping concentration than the second region (222).

3. The electronic circuit of claim 2,
wherein a distance between the base region (23) and the second region (222) of the collector region (22) is selected from between 1 micrometer and 100 micrometers.

4. The electronic circuit of any one of claims 1 to 3,
wherein the base region (23), in a lateral plane of the semiconductor body (100), surrounds the emitter region (21), and
wherein the collector region (22), in the lateral plane of the semiconductor body (100) surrounds the base region (23).

5. The electronic circuit of any one of claims 1 to 4,
wherein the trigger element (3) comprises a resistor.

6. The electronic circuit of any one of claims 1 to 4,
wherein the trigger element (3) comprises a diode.

7. The electronic circuit of any one of the preceding claims,
wherein the trigger element (3) is integrated in a polysilicon layer (7) formed above a first surface (101) of the semiconductor body (100).

8. The electronic circuit of any one of the preceding claims,
wherein the bipolar transistor (2) is a PNP bipolar transistor.

9. The electronic circuit of any one of the preceding claims,
wherein a breakdown voltage of the Avalanche diode (4) is between 30 V and 1000 V.
